# EUROPÄISCHE PATENTSCHRIFT

(11) **EP 2 274 507 B1**
(45) Veröffentlichungstag und Bekanntmachung des Hinweises auf die Patenterteilung: **21.09.2011**
(21) Anmeldenummer: 09745491.2
(22) Anmeldetag: 21.04.2009
(51) Int. Cl.: F01N 5/02, H01L 35/30, H01L 35/32

(54) **KÜHLUNG FÜR EINEN THERMOELEKTRISCHEN GENERATOR (TEG)**
COOLING SYSTEM FOR A THERMOELECTRIC GENERATOR (TEG)
REFROIDISSEMENT D'UN GÉNÉRATEUR THERMOÉLECTRIQUE (TEG)

(30) Priorität: 15.05.2008 DE 102008023832
(43) Veröffentlichungstag der Anmeldung: 19.01.2011
(73) Patentinhaber: Bayerische Motoren Werke Aktiengesellschaft, 80809 München (DE)
(72) Erfinder: RICHTER, Rainer, 81247 München (DE); MAZAR, Boris, 80807 München (DE); RUETH, Stefan, 85748 Garching (DE); SCHRÖTER, Gunter, 81829 München (DE); MÜNCH, Stefan, 85235 Odelzhausen (DE)
(86) Internationale Anmeldenummer: PCT/EP2009/002884
(87) Internationale Veröffentlichungsnummer: WO 2009/138157

(56) Entgegenhaltungen:
- EP-A- 1 475 532
- EP-A- 1 811 646
- WO-A-2007/002891
- DE-A1-102006 019 282

## Beschreibung

Die Erfindung betrifft eine Kühlung für einen thermoelektrischen Generator (TEG) mit den Merkmalen aus dem Oberbegriff des Patentanspruchs 1.

Zum technischen Umfeld wird beispielsweise auf die deutsche Offenlegungsschrift DE 10 2006 019 282 A1 hingewiesen. Aus dieser ist ein Abgasrückführsystem für eine Brennkraftmaschine mit einem Abgasstrang und einem Frischluftstrang bekannt, wobei der Abgasstrang und der Frischluftstrang abgasführend mit einer Abgasrückführleitung verbunden sind. Die Abgasrückführleitung weist einen Abgaskühler auf, an dem ein thermoelektrischer Generator (TEG) mit seiner Heißseite zur Stromerzeugung angeordnet ist. Durch die vorgeschlagene Ausgestaltung wird mit einem minimalen Aufwand ein zusätzlicher Stromerzeuger zur Verfügung gestellt. Um für die Stromerzeugung ständig ein ausreichendes Temperaturgefälle für den TEG vorliegen zu haben, ist der TEG auf seiner Kaltseite in den Kühlmittelkreislauf der Brennkraftmaschine eingebunden.

Aus der europäischen Patentanmeldung EP 1 475 532 A2 ist ebenfalls eine Brennkraftmaschine mit einem Ansaugstrang und einem Abgasstrang bekannt. Auch diese Brennkraftmaschine weist ein Abgasrückführsystem auf, mit dem Abgas vom Abgasstrang durch eine Abgasrückführleitung in den Frischluftstrang rückgefördert werden kann. Auch an diese Abgasrückführleitung ist ein thermoelektrischer Generator (TEG) mit seiner Heißseite zur Stromerzeugung angeordnet. In einem speziellen Ausführungsbeispiel weist der TEG einen eigenen Kühlmittelkreislauf auf, der gleichzeitig zur Kühlung eines elektrischen Wechselrichters vorgesehen ist. Der Wechseltrichter seinerseits dient zur Drehzahlregelung einer elektrischen Maschine, die alternativ oder gleichzeitig mit der Brennkraftmaschine betreibbar ist, einem sog. Hybridantrieb für Kraftfahrzeuge.

Weiter ist aus der internationalen Patentanmeldung WO 2007/002891 A2, von der die vorliegende Erfindung ausgeht, eine Kühlung für einen Thermoelektrischen Generator bekannt, der in einem Abgasstrang einer Brennkraftmaschine zur Stromerzeugung unter Ausnutzung der Abgaswärmeenergie, insbesondere der Verlustwärmeenergie, angeordnet ist. Um die Stromerzeugung effizienter darzustellen, verfügt der Thermoelektrische Generator über einen eigenen Kühlmittelkreislauf.

Auch wenn in dem zitierten Stand der Technik kein prinzipieller Nachteil erkennbar ist, liegt der vorliegenden Erfindung die Aufgabe zugrunde, die Abgaswärmeenergie noch besser auszunutzen.

Diese Aufgabe wird durch das Merkmal im kennzeichnenden Teil des Patentanspruchs 1 gelöst.

Durch die erfindungsgemäße Ausgestaltung stellt der TEG letztlich einen erweiterten Abgaswärmetauscher dar. Daher bestehen ergänzend zur Hauptfunktion, nämlich der Erzeugung von elektrischer Energie, zusätzliche Funktionalitäten durch die Auskopplung der Wärme aus dem Abgas. Diese betreffen vor allem den Kaltstart bzw. Niedriglastphasen der Brennkraftmaschine, in denen das Getriebe bzw. das Hinterachsgetriebe nur langsam warm werden. Folgende Funktionen zur Warmlaufbeschleunigung bestehen durch den TEG:
- Unterstützung der Erwärmung einer Fahrgastzelle eines Fahrzeuges durch Zuheizung mit dem Kühlmittelkreislauf.
- Schnellerwärmung des Getriebeschmiermittels mit dem Kühlmittelkreislauf.
- Unterstützung der Erwärmung des Brennkraftmaschinenschmiermittels und/oder von Brennkraftmaschinenkomponenten und damit Beschleunigung der Brennkraftmaschinenerwärmung.
- Schnellerwärmung von Fahrwerkskomponenten, wie beispielsweise einem Hinterachsgetriebe über dessen Schmiermittel.

Die Verteilung der Wärmeströme in dem Kühlmittelkreislauf kann hierbei beispielsweise zentral erfolgen, beispielsweise mit Hilfe eines Multifunktionalventils oder dezentral durch Mono-/2/2-Wege-Ventile, wie sie z. B. in einem integrierten Heiz-/Klimagerät eingesetzt werden. Durch die erfindungsgemäße Ausgestaltung ergibt sich eine deutlich höhere elektrische Leistung des TEG und es ist ein flexiblerer Betrieb als bei einer TEG-Luftkühlung möglich. In vorteilhafter Weise wird durch die Entlastung des elektrischen Generators der Kraftstoffverbrauch reduziert (Reduzierung der CO₂-Emissionen). Erfindungsgemäß sind die Hauptvorteile zu sehen im Zusatznutzen der Warmlaufbeschleunigung beispielsweise von Getriebeschmiermittel, Brennkraftmaschinenschmiermittel und Fahrgastzellenheizung. In vorteilhafter Weise trägt die erfindungsgemäße Ausgestaltung weiter zur Beschleunigung der TEG-Erwärmung bei und verlangsamt in Niedriglastpunkten die Abkühlung des TEG.

Die Ausgestaltung gemäß Patentanspruch 2 ist eine besonders bevorzugte Ausführungsvariante für die Kühlung eines TEG.

Mit der Ausgestaltung gemäß Patentanspruch 3 ist es möglich, durch Nachlauf der Kühlmittelpumpe das "Nachheizen" des TEG und somit eine evtl. Überhitzung des TEG zu vermeiden.

Bevorzugte Anordnungsorte für den Wärmetauscher ergeben sich aus den Ortsangaben gemäß Patentanspruch 4.

Die Ausgestaltung gemäß Patentanspruch 5 erübrigt in vorteilhafter Weise die alternative Drosselung des TEG-Kühlmittelkreislaufs über die Kühlmittelpumpe der Brennkraftmaschine.

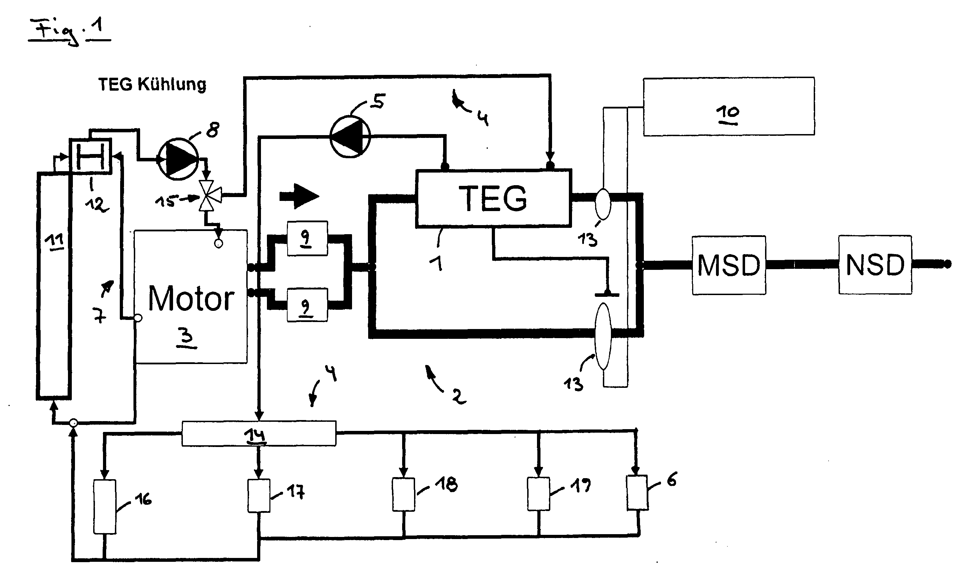

Fig. 1 zeigt schematisch eine Einbindung eines erfindungsgemäß gekühlten thermoelektrischen Generators (TEG) in einem Abgasstrang einer Brennkraftmaschine.

Unter einem thermoelektrischen Generator (TEG) wir nicht nur ein einzelner TEG verstanden, sondern es kann sich auch um eine Anordnung mehrerer TEG in einem Block oder sonstiger Anordnung handeln. Funktionsprinzip und Wirkungsweise eines TEG werden im Folgenden nicht weiter erörtert, da diese aus dem Stand der Technik hinreichend bekannt sind. Auch auf eine elektrische Einbindung des TEG in ein Gesamtkonzept wird nicht explizit eingegangen.

Fig. 1 zeigt schematisch eine Einbindung eines erfindungsgemäß gekühlten thermoelektrischen Generators (TEG) 1 in einen an eine Brennkraftmaschine 3 angeordneten Abgasstrang 2. Der Abgasstrang 2 ist brennkraftmaschinennah zweiflutig ausgeführt, wobei in jedem Teilabgasstrang jeweils eine Abgasreinigungsanlage 9 angeordnet ist. In Strömungsrichtung des Abgases, nach den Abgasreinigungsanlagen 9 münden die Teilabgasstränge in einen gemeinsamen Abgasstrang 2, der sich anschließend wieder in zwei Teilabgasstränge aufteilt, wobei in einem Teilabgasstrang der thermoelektrische Generator 1 mit seiner Heißseite angeordnet ist. Beide Teilabgasstränge sind vorzugsweise derart dimensioniert, dass durch jeden Teilabgasstrang der maximale Abgasmassenstrom geführt werden kann. In beiden Teilabgassträngen ist jeweils ein Abgasventil 13 angeordnet, wobei das Abgasventil 13 im vorliegenden Ausführungsbeispiel hinter dem thermoelektrischen Generator 1 angeordnet ist. Nach den Abgasventilen 13 münden die Teilabgasstränge wieder in den gemeinsamen Abgasstrang 2, wobei in Strömungsrichtung des Abgases zuerst ein nicht bezifferter Mittelschalldämpfer und weiter ein ebenfalls nicht bezifferter Nachschalldämpfer in den Abgasstrang 2 integriert sind.

Die Abgasventile 13 sind in Abhängigkeit vom Betriebszustand der Brennkraftmaschine 3 über ein Steuergerät 10 steuerbar. Weiter weist die Brennkraftmaschine 3 einen primären Kühlmittelkreislauf 7 mit einer ersten Kühlmittelpumpe 8 sowie einen ersten Wärmetauscher 11 und ein Thermostatventil 12 zur Temperierung der Brennkraftmaschine 3 auf.

In einem weiteren Ausführungsbeispiel das Abgasventil 13 in Strömungsrichtung des Abgases auch vor dem thermoelektrischen Generator 1 angeordnet sein. Als Abgasventil 13 kann beispielsweise eine Abgasklappe oder ein Drehschieber oder ein sonstiges Absperrorgan eingesetzt werden. Auch kann der Abgasstrang 2 brennkraftmaschinennah nach einem Abgaskrümmer einflutig ausgeführt sein. Auch die Anordnung der Abgasreinigungsanlagen 9 kann vom dargestellten Ausführungsbeispiel abweichen. Bei dem Steuergerät 10 kann es sich beispielsweise auch um ein Steuergerät für die Brennkraftmaschine 3 handeln.

Erfindungsgemäß ist zur Kühlung des thermoelektrischen Generators 1 auf seiner Kaltseite ein eigener Kühlmittelkreislauf 4 vorgesehen. In diesem Kühlmittelkreislauf 4 ist eine zweite Kühlmittelpumpe 5 vorgesehen sowie ein Ventil 14, im vorliegenden Ausführungsbeispiel ein Multifunktionsventil, wie es beispielsweise aus integrierten Heiz-/Klimageräten bekannt ist. Über das Ventil 14 kann ein von dem thermoelektrischen Generator 1 aufgeheiztes Kühlmittel zu einem zweiten Wärmetauscher 6 zum Aufwärmen von Brennkraftmaschinen- und/oder Fahrwerks- und/oder Getriebekomponenten und/oder einer Fahrzeugfahrgastzelle verwendet werden.

Im vorliegenden Ausführungsbeispiel sind alternativ zu dem zweiten Wärmetauscher 6 ein dritter Wärmetauscher 16 für eine Brennkraftmaschinenkomponente, wie beispielsweise eine Schmiermittelwanne, ein vierter Wärmetauscher 17 für eine Fahrwerkskomponente, wie beispielsweise einem Hinterachsgetriebe, ein fünfter Wärmetauscher 18 für eine Getriebekomponente, wie beispielsweise das Getriebeschmiermittel sowie ein sechster Wärmetauscher 19 für eine Fahrzeugfahrgastzelle vorgesehen.

In dem in Fig. 1 dargestellten Ausführungsbeispiel, ist der Kühlmittelkreislauf 4 des thermoelektrischen Generators 1 auch kühlmittelführend mit dem primären Kühlmittelkreislauf 7 der Brennkraftmaschine 3 verbunden.

Durch die erfindungsgemäße Ausgestaltung stellt der TEG letztlich einen erweiterten Abgaswärmetauscher dar. Daher bestehen ergänzend zur Hauptfunktion, nämlich der Erzeugung von elektrischer Energie, zusätzliche Funktionalitäten durch die Auskopplung der Wärme aus dem Abgas. Diese betreffen vor allem den Kaltstart bzw. Niedriglastphasen der Brennkraftmaschine, in denen das Getriebe bzw. das Hinterachsgetriebe nur langsam warm werden. Folgende Funktionen zur Warmlaufbeschleunigung bestehen durch den TEG:
- Unterstützung der Erwärmung einer Fahrgastzelle eines Fahrzeuges durch Zuheizung mit dem Kühlmittelkreislauf.
- Schnellerwärmung des Getriebeschmiermittels mit dem Kühlmittelkreislauf.
- Unterstützung der Erwärmung des Brennkraftmaschinenschmiermittels und/oder von Brennkraftmaschinenkomponenten und damit Beschleunigung der Brennkraftmaschinenerwärmung.
- Schnellerwärmung von Fahrwerkskomponenten, wie beispielsweise einem Hinterachsgetriebe über dessen Schmiermittel.

### Bezugszeichenliste:

- 1.: Thermoelektrischer Generator (TEG)
- 2.: Abgasstrang
- 3.: Brennkraftmaschine
- 4.: Kühlmittelkreislauf
- 5.: zweite Kühlmittelpumpe
- 6.: zweiter Wärmetauscher
- 7.: primärer Kühlmittelkreislauf
- 8.: erste Kühlmittelpumpe
- 9: Abgasreinigungsanlage
- 10.: Steuergerät
- 11.: erster Wärmetauscher
- 12.: Thermostatventil
- 13.: Abgasventil
- 14.: Ventil
- 15.: Mischventil
- 16.: dritter Wärmetauscher Brennkraftmaschinenkomponente
- 17.: vierter Wärmetauscher Fahrwerkskomponente
- 18.: fünfter Wärmetauscher Getriebekomponente
- 19.: sechster Wärmetauscher Fahrgastzelle

## Patentansprüche

1. Kühlung für einen Thermoelektrischen Generator (TEG) (1), der in einem Abgasstrang (2) einer Brennkraftmaschine (3) zur Stromerzeugung unter Ausnutzung einer Abgaswärmeenergie angeordnet ist, wobei der TEG (1) über einen eigenen Kühlmittelkreislauf (4) verfügt,
**dadurch gekennzeichnet, dass** der Kühlmittelkreislauf (4) zum Aufwärmen von Brennkraftmaschinen- und/oder Fahrwerks- und/oder Getriebekomponenten und/oder einer Fahrgastzelle vorgesehen ist.

2. Kühlung nach Patentanspruch 1,
**dadurch gekennzeichnet, dass** in dem Kühlmittelkreislauf (4) eine Kühlmittelpumpe (5) und ein Wärmetauscher (6) angeordnet sind.

3. Kühlung nach Patentanspruch 2,
**dadurch gekennzeichnet, dass** die Kühlmittelpumpe (5) elektrisch oder mechanisch antreibbar ist.

4. Kühlung nach Patentanspruch 2 oder 3,
**dadurch gekennzeichnet, dass** der Wärmetauscher (6) in einem Brennkraftmaschinenraum und/oder in einem Radhaus und/oder unter Flur einer Fahrzeugkarosserie angeordnet ist.

5. Kühlung nach einem der Patentansprüche 1 bis 4, wobei die Brennkraftmaschine einen primären Kühlmittelkreislauf aufweist,
**dadurch gekennzeichnet, dass** der Kühlmittelkreislauf (4) mit dem primären Kühlmittelkreislauf (7) in Wirkverbindung ist.

## Claims

1. A cooling system for a thermoelectric generator (TEG) (1) disposed in an exhaust branch (2) of an internal combustion engine (3) for generating current by using the thermal energy of the exhaust gas, wherein the TEG (1) has an individual coolant circuit (4), **characterised in that** the coolant circuit (4) is provided for warming up components of the engine and/or of the running gear and/or gearbox and/or a passenger compartment.

2. A cooling system according to claim 1,
**characterised in that** a coolant pump (5) and a heat exchanger (6) are disposed in the cooling circuit (4).

3. A cooling system according to claim 2,
**characterised in that** the coolant pump (5) is electrically or mechanically driven.

4. A cooling circuit according to claim 2 or claim 3,
**characterised in that** the heat exchanger (6) is disposed in an internal combustion engine space and/or in a wheel housing and/or under the floor of a vehicle body.

5. A cooling system according to any of claims 1 to 4, wherein the engine has a primary cooling circuit,
**characterised in that** the cooling circuit (4) is connected in operation to the primary cooling circuit (7).

## Revendications

1. Système de refroidissement d'un générateur thermoélectrique (TEG) (1), installé dans une conduite de gaz d'échappement (2) d'un moteur à combustion interne (3) pour générer du courant en utilisant l'énergie thermique des gaz d'échappement,
- le générateur (TEG) (1) ayant son propre circuit d'agent de refroidissement (4),
système **caractérisé en ce que**
le circuit d'agent de refroidissement (4) est prévu pour chauffer un composant du moteur à combustion interne et/ou du châssis et/ou de la transmission et/ou de l'habitacle.

2. Système de refroidissement selon la revendication 1,
**caractérisé en ce que**
le circuit d'agent de refroidissement (4) est équipé d'une pompe d'agent de refroidissement (5) et d'un échangeur de chaleur (6).

3. Système de refroidissement selon la revendication 2,
**caractérisé en ce que**
la pompe d'agent de refroidissement (5) est une pompe à entraînement électrique ou mécanique.

4. Système de refroidissement selon la revendication 2 ou 3,
**caractérisé en ce que**
l'échangeur de chaleur (6) est installé dans l'enceinte du moteur à combustion interne et/ou dans un logement de roue et/ou sous le plancher de la carrosserie du véhicule.

5. Système de refroidissement selon l'une des revendications 1 à 4, le moteur à combustion interne ayant un circuit primaire d'agent de refroidissement,
système **caractérisé en ce que**
le circuit d'agent de refroidissement (4) coopère avec le circuit primaire d'agent de refroidissement (7).
